# EUROPEAN PATENT SPECIFICATION

(11) **EP 0 732 428 B1**
(45) Date of publication and mention of the grant of the patent: **17.05.2000**
(21) Application number: 96301467.5
(22) Date of filing: 05.03.1996
(51) Int. Cl.: C30B 23/02, H01F 10/30, H01F 10/20, H01F 41/20

(54) **Method for making and artice comprising a spinel-structure material on a substrate**
Verfahren zur Herstellung eines Gegenstands, welcher aus einem eine Spinellstruktur aufweisenden auf ein Substrat angeordneten Material besteht
Méthode pour fabriquer un article comprenant au matériau à structure spinelle sur un substrat

(30) Priority: 17.03.1995 US 406084
(43) Date of publication of application: 18.09.1996
(73) Proprietor: AT&T Corp., New York, NY 10013-2412 (US)
(72) Inventor: Gyorgy, Ernst Michael, Madison, New Jersey 07940 (US); Suzuki, Yuri, Bridgewater, New Jersey 08807 (US); Phillips, Julia Mae, Mountainside, New Jersey 07092 (US); Van Dover, Robert Bruce, Maplewood, New Jersey 07040 (US)
(74) Representative: Johnston, Kenneth Graham

(56) References cited:
- US-A- 3 421 933
- JOURNAL OF APPLIED PHYSICS, vol. 63, no. 8, PART 02B, 15 April 1988, pages 3774-3776, XP000070019 ABE M ET AL: "FERRITE-ORGANIC MULTILAYER FILM FOR MICROWAVE MONOLITHIC INTEGRATE CIRCUITS PREPARED BY FERRITE PLATING BASED ON THE SPRAY-SPIN- COATING METHOD"
- PHYSICAL REVIEW, B. CONDENSED MATTER, vol. 45, no. 4, 15 January 1992, pages 1838-1850, XP000291832 LIND D M ET AL: "GROWTH AND STRUCTURAL CHARACTERIZATION OF FE3O4 AND NIO THIN FILMS AND SUPERLATTICES GROWN BY OXYGEN-PLASMA-ASSISTED MOLECULAR-BEAM EPITAXY"
- JOURNAL OF APPLIED PHYSICS, vol. 75, no. 10, 15 May 1994, NEW YORK US, page 6124 XP000457051 R.B.VAN DOVER ET AL: "Deposition and properties of NiFe2O4 thin films"
- JOURNAL OF APPLIED PHYSICS, vol. 75, no. 3, 1 February 1994, pages 1676-1680, XP000430054 WILLIAMS C M ET AL: "THE MAGNETIC AND STRUCTURAL PROPERTIES OF PULSED LASER DEPOSITED EPITAXIAL MNZN-FERRITE FILMS"
- CHEMICAL ABSTRACTS, vol. 72, no. 16, 20 April 1970 Columbus, Ohio, US; abstract no. 84330e, CH.S.MOKIEVSKII: "Morphological features of single-crystal layered films of ferrites" page 432; column 2; XP002003115 & FERRITY,DOKL.VSES.SOVESHCH,5TH, 1968, SU, pages 456-463,

## Description

### Field of the Invention

This invention pertains to a method for making articles (e.g., high frequency communication equipment, low power/high speed computers) that comprise a spinel-structure (s.s.) metal oxide (typically ferrite) layer on a substrate. Typically the article comprises a high frequency inductor, resonator, or other feature that requires the presence of a layer of high permeability/low conductivity ferrite.

### Background of the Invention

As is well known, conventional bulk ferrites (e.g., bulk (Ni,Zn) Fe₂O₄) are generally not useful for devices (e.g., inductors) that operate at frequencies above about 10 MHz. However, ferrites in thin film form are known to be potentially useful for high frequency applications (e.g., up to about 100 MHz and even higher).

Several techniques have been used to deposit s.s. ferrite (e.g., NiFe₂O₄, (Ni,Zn) Fe₂O₄) thin films on, e.g., MgO substrates. Among them are pulsed laser deposition, sputtering and e-beam reactive evaporation. See, for instance, C. M. Williams et al., Applied Physics, Vol. 75(3), p. 1676 (1994); and D. T. Margulies et al., Materials Research Society Symposium Proceedings, Vol. 341, p. 53 (1994).

Prior art methods of making ferrite films generally require growth (and/or annealing) at relatively high temperatures, e.g., 600-800°C. Absent such high temperature treatment the films typically are of low crystalline and/or magnetic quality. However, such high temperature treatment is typically not compatible with conventional semiconductor processing methods. Furthermore, the high temperature treatment can lead to volatilization of constituents such as Zn or Mn (for instance, from (Mn, Zn) Fe₂O₄), and to, generally undesirable, chemical interaction of the film with the substrate.

In view of the potential importance of articles that comprise a s.s. ferrite (or other s.s. metal oxide) thin film on a substrate, it would be highly desirable to have available a method that enables growth of such films of high quality at a relatively low temperature. This application discloses such a method.

By a "spinel-structure" (or "s.s.") ferrite or other metal oxide we mean herein a metal oxide that has the same crystal structure as spinel (MgAl₂O₄). For an illustration of the spinel structure see, for instance, C. Kittel, "Introduction to Solid State Physics", 2nd edition, Wiley & Sons (1956), p. 447. Compilations of metal oxides that have the spinel structure are readily available. See, for instance, G. Blasse, "Crystal Chemistry and Some Magnetic Properties of Mixed Metal Oxides with Spinel Structure", Philips Res. Reports Supplements, 1964 NO. 3, Eindhoven, The Netherlands.

M. Abe et al., J. Applied Physics, Vol. 63(8), page 3774, discloses formation of a ferrite-organic multilayer film by a spray-spin-coating method at low temperature, e.g. 80°C.

### Summary of the Invention

The invention is as defined by the claims. Broadly speaking, the invention is embodied in an improved method of making an article that comprises a layer of s.s. metal oxide, typically ferrite, and in the article made by the method.

More specifically, the method comprises providing a substrate, and depositing a first s.s.metal oxide layer (typically of thickness less than about 1 µm) on the substrate. At least the portion of the substrate that is to be in contact with the s.s. metal oxide layer is selected to have cubic crystal symmetry, with a lattice constant in the range 0.79 nm to 0.89 nm (preferably within 0.015 nm of the lattice constant of the first s.s. metal oxide), and the first s.s. metal oxide layer is formed on the portion at a temperature of at most 500°C. The article is completed without heating the first s.s. metal oxide layer above 500°C. The first metal oxide layer can, but need not, consist of two or more s.s. metal oxide layers (typically ferrite layers) of different compositions.

In currently preferred embodiments of the invention the substrate comprises a substrate body that has a major surface, and typically does not have a lattice constant in the 0.79-0.89 nm range. Disposed on the major surface is a template layer that consists of material having cubic symmetry, with a lattice constant in the 0.79-0.89 nm range. The template layer is a s.s. metal oxide layer, possibly a ferrite layer, and the first s.s. metal oxide layer is formed on the template layer. Typically, but not necessarily, the first s.s. metal oxide layer is a ferrite layer. The template layer will frequently be less than 0.2 µm thick. The template layer is exposed to a temperature of at least 600°C for a time sufficient for crystal structure improvement.

The composition of the template can, but need not, be different from the composition of the first s.s. metal oxide layer. The first s.s. metal oxide layer can, but need not, have essentially uniform composition throughout the layer thickness. Indeed, we contemplate articles that comprise two or more ferrite layers disposed on the template layer, the ferrite layers differing from each other with respect to composition and/or magnetic properties. The template layer can, but need not, be magnetic material.

Exemplarily, the substrate body is SrTiO₃ (STO), the template layer is NiFe₂O₄ grown at 600°C and annealed at 1000°C for 30 minutes in air, and the first s.s. metal oxide layer is also NiFe₂O₄, deposited at 400°C and not annealed. Such a ferrite layer can have excellent magnetic properties, essentially the same as bulk NiFe₂O₄.

In a further exemplary embodiment the substrate body is STO, the template layer is CoCr₂O₄, and the first s.s. metal oxide layer is CoFe₂O₄, deposited at 400°C. The thus produced ferrite layer can be magnetically hard, with a square M-H loop and high coercive force. On the other hand, a similarly produced Mn_{.5} Zn_{.5} Fe₂O₄ layer or NiFe₂O₄ layer can be magnetically soft and have full bulk saturation magnetization.

More generally, among the ferrites contemplated for use in articles according to the invention are MnₓZn_{y}Fe_{z}O₄ and NiₓZn_{y}Fe_{z}O₄, with 0.15 < x < 0.75, 0 ≤ y < 0.6, 1.5 < z < 2.5, x + y + z = 3, CoFe₂O₄ and Ni_{x'} Fe_{y'} Cr_{2'}, with 0.5 < x' <1.5, 0.5 < y' < 1.5, 0.5 < z' < 1.5, x' + y' + z' = 3.

### Brief Description of the Drawings

FIG. 1 schematically depicts a portion of an exemplary article according to the invention; and
FIGs. 2-5 present magnetic data for some exemplary embodiments of the invention, together with comparison data.

### Detailed Description

A significant aspect of the invention is the provision of a substrate that differs from prior art substrates *inter alia* with regard to lattice constant, as will now be discussed.

As demonstrated, for instance, by the cited references, MgO is a common prior art substrate material for s.s. ferrites such as NiFe₂O₄. Both of these materials have cubic crystal symmetry, with the former having a lattice constant of 0.4212 nm, and the latter of 0.8339 nm. The former clearly is fairly closely matched to the half-unit-cell dimension of the latter, and therefore is, by conventional criteria, a good substrate for the epitaxial growth of, e.g., NiFe₂O₄. However, we have found that a serious problem exists. The problem is most significant in the low temperature growth of magnetic metal oxide films, typically s.s. ferrite films, and will be described by reference to the low temperature growth of a film of a typical ferrite (namely, NiFe₂O₄) on a typical prior art substrate (namely, MgO). No limitation to this ferrite and/or substrate is implied.

In the early stage of low temperature (e.g., ≤500°C) growth of NiFe₂O₄ on MgO, the spinel nucleates at various locations on the substrate, followed by growth of NiFe₂O₄ islands from the nuclei. If adjacent islands nucleated an odd number of MgO lattice constants apart then there will be a half-unit-cell intergrowth when the growing islands impinge on each other. This intergrowth typically leads to an extensive disordered region, exemplarily about 5 nm wide, that surrounds crystallites of typical lateral dimension 30 nm. In turn, we found that magnetic interaction between the crystallites and the surrounding disordered region generally leads to poor magnetic properties of the film, e.g., relatively low magnetization.

Film growth at temperatures above about 600°C generally leads to less formation of disordered regions, and high temperature annealing of a low temperature film generally results in substantial ordering of the disordered regions, with attendant improvement of the magnetic properties of the film.

Our analysis of the low temperature growth of s.s. ferrite films such as NiFe₂O₄ on MgO (and other prior art substrates such as STO, Y_{0.15} Zr_{0.85}O₂ (YSZ or cubic zirconia) and Si) has resulted in the realization that the conventionally used substrates are generally unable to support low temperature growth of s.s. ferrite films having technologically useful magnetic properties because of the disordered regions that form in consequence of the approximately 2:1 lattice constant ratio between s.s. ferrites and conventional substrates.

The above described problems can be greatly reduced or eliminated if at least the substrate region that is to be in contact with the s.s. ferrite (or possibly other s.s. metal oxide) layer is selected to have an approximately 1:1 lattice constant ratio with the layer. This can be achieved by selection of a substrate body that has cubic lattice symmetry and lattice constant approximately equal to that of the layer, typically in the range 0.79-0.89 nm. For instance, a ferrite film (e.g., NiFe₂O₄) can be formed on a s.s. metal oxide substrate such as CoCr₂O₄. Unfortunately, single crystal wafers of most s.s. metal oxides and of other, otherwise suitable, substrate materials, are not readily available, and thus it is generally not feasible to substitute such substrates for the conventionally used substrates. However, in principle, use of, for instance, a s.s. substrate body of appropriate lattice constant can support low temperature growth of high quality s.s. ferrite films.

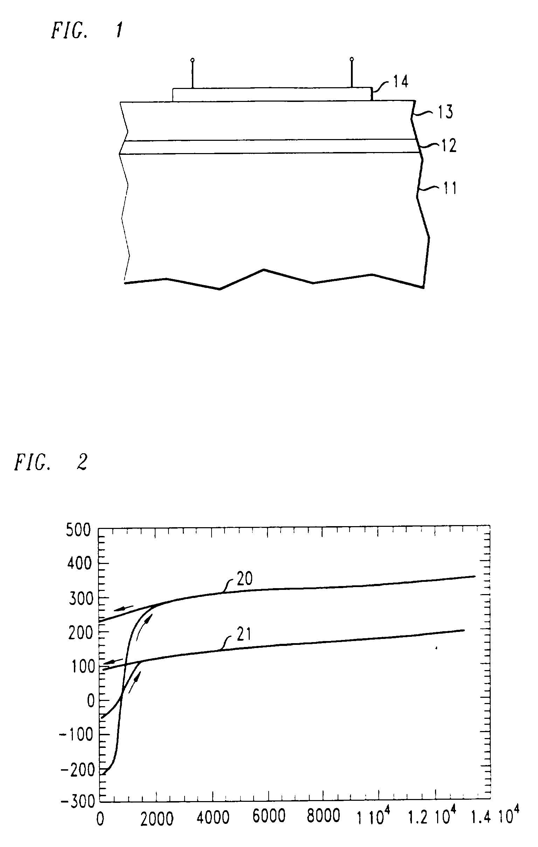

We have solved the above discussed problem by provision of an appropriate template layer between a conventional substrate body and the s.s. metal oxide (typically ferrite) layer. See FIG. 1, wherein numerals 11-14 refer to the substrate body, template layer, s.s. ferrite film and patterned conductor, respectively. Currently preferred substrate bodies comprise such readily available materials as STO, YSZ and Si. Substrate bodies that comprise Al₂O₃, MgO or MgAl₂O₄ are less preferred since they frequently exhibit diffusion of Mg and/or Al into the template layer at high temperatures.

We will next describe the growth of an exemplary template layer according to the invention (CoCr₂O₄) on (100) oriented STO, followed by growth of an exemplary ferrite film (NiFe₂O₄) on the template layer.

A conventional (100)-oriented STO wafer was mounted in a conventional pulsed laser deposition system (KrF excimer laser, 248 nm wavelength). The atmosphere in the deposition chamber was set to 0.133 Pa (1 mTorr) pressure 0.001 Pa (0.01 mTorr) O₂, 0.132 Pa (0.99mTorr) N₂), and the wafer heated to 600°C. A CoCr₂O₄ target was laser ablated with 4J/cm² pulses at 10Hz repetition rate, resulting in a growth rate of about 100 nm/hr. After deposition of about 100 nm of CoCrO₂ and cooling of the substrate body/template layer combination, the template layer was annealed in conventional apparatus at 1000°C in air for 30 minutes. The thus produced template layer had (100) orientation and exhibited excellent crystal quality, as determined by XRD (Δω = 0.72° for (400) peak) and RBS (χₘᵢₙ = 14%).

Subsequently, a NiFe₂O₄ layer of approximate thickness 150 nm was deposited on the template layer substantially as described above, except that the substrate was maintained at 400°C and the atmosphere was 0.133 Pa (1 mTorr) O₂. After completion of deposition and cool-down, the ferrite (NiFe₂O₄) layer was characterized by XRD, RBS and magnetization measurements. The former measurements showed that the crystal quality of the ferrite film was substantially as good as that of the template layer (Δω and χₘᵢₙ of the ferrite film only slightly larger than those of the template). The latter measurements (carried out with a conventional vibrating sample magnetometer) showed that the room temperature magnetization M(H) of the ferrite film according to the invention was comparable to that of a prior art NiFe₂O₄ film deposited on STO and annealed at 1000°C. Exemplary results are shown in FIG. 2, wherein curves 20 and 21 are, respectively, for a film according to the invention and a comparison film deposited under essentially the same conditions directly on a STO substrate body. As can be readily seen from FIG. 2, the ferrite film made according to the invention has significantly higher magnetization than the comparison film, demonstrating the considerable improvement in magnetic properties that can be achieved by the use of an appropriate template layer.

**Table I**

| template | orientation on (100) STO | Δω(°) | χₘᵢₙ (%) | lattice constant (nm) |
|---|---|---|---|---|
| CoCr₂O₄ | (400) | 0.72 | 14 | 0.838 |
| Mg₂TiO₄ | (400) | 0.39 | 30 | 0.845 |
| FeGa₂O₄ | (220) | 2.65 | | |
| NiMn₂O₄ | (400) | 0.5 | | 0.845 |

**Table II**

| template | orientation on (100) YSZ | Δω(°) | χₘᵢₙ (%) | lattice constant (nm) |
|---|---|---|---|---|
| CoCr₂O₄ | (111) | 0.56 | 9 | 0.838 |
| Mg₂TiO₄ | (111) | 0.71 | | 0.845 |
| NiMn₂O₄ | (111) | 0.26 | 9 | 0.845 |

Tables I and II summarize Δω and χₘᵢₙ results for exemplary template layers produced, respectively, substantially as described above on (100) STO and (100) YSZ, except that the layers other than CoCr₂O₄ on STO were grown in 1mTorr O₂. As can be seen from the Tables, CoCr₂O₄, NiMn₂O₄ and Mg₂ TiO₄ form (111)-oriented layers on (100) YSZ. FeGa₂O₄ does not have a stable crystalline phase on (100) YSZ under the recited conditions, and forms a (110)-oriented layer on (100) STO.

Of the four metal oxides of the tables, CoCr₂O₄ and NiMn₂O₄ yielded layers of excellent crystallinity on (100) STO and (100) YSZ and are preferred. Other possible, but currently non-preferred s.s. metal oxides are MgCr₂O₄, MgTi₂O₄, MnAl₂O₄ and CuMn₂O₄.

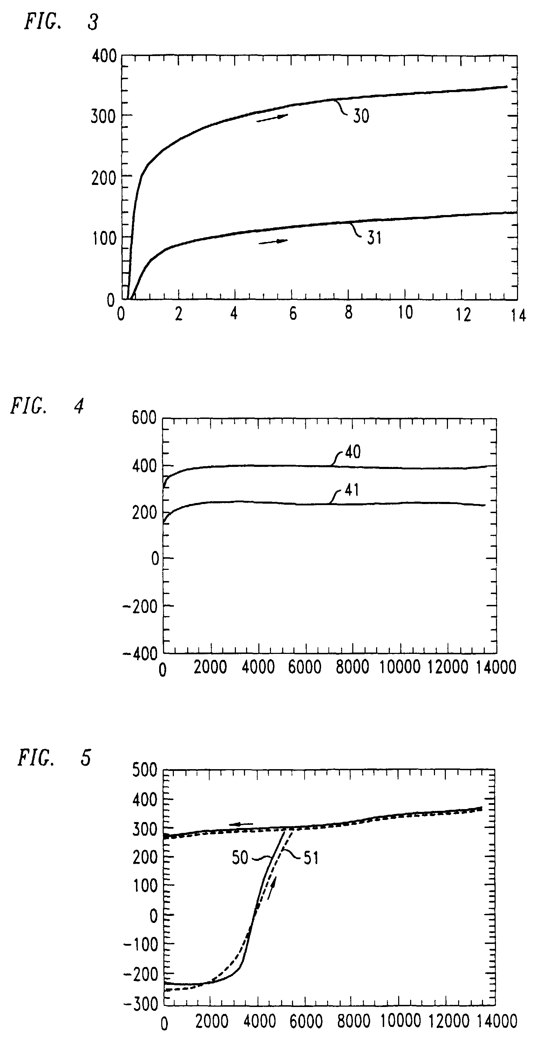

FIG. 3 shows the magnetization (30) of a NiFe₂O₄ ferrite layer according to the invention (sputter deposited at 400°C, no subsequent heat treatment above that temperature), deposited on a NiFe₂O₄ template layer (sputter deposited at 600°C, annealed 30 minutes at 1000°C), which in turn was deposited on a conventional (100) STO substrate body. The magnetization due to the template layer has been subtracted from the total measured magnetization, to yield the values of curve 30.

For comparison purposes, FIG. 3 also shows the magnetization of a prior art NiFe₂O₄ film (sputter deposited at 600°C on STO). Clearly, the ferrite film according to the invention has substantially higher magnetization than the prior art film.

Similar data are shown in FIG. 4, wherein curve 40 pertains to a substrate/template/ferrite combination according to the invention (STO substrate, CoCr₂O₄ template, Mn₁₋ₓZnₓFe₂O₄, ferrite layer, with x ∼ 0.5, grown at 400°C by pulsed laser deposition), and curve 41 pertains to a prior art comparison layer (Mn₁₋ₓ ZnₓFe₂O₄ on STO, x ∼ 0.5). Again, the layer according to the invention has substantially higher magnetization.

FIG. 5 shows the magnetization of an exemplary "hard" magnetic material (CoFe₂O₄) according to the invention (50), and of the corresponding prior art material (51). Curve 50 shows an improved (i.e., more square) M-H loop.

In preferred embodiments the template material is selected such that most (i.e., >50%, desirably ≳ 75%) of the lattice mismatch between the substrate body and the first oxide layer is taken up at the substrate/template interface. By this we mean that | 2aₛ - aₜ | > | aₜ - a_{f} |, where aₛ, aₜ and a_{f} are the lattice constants of the substrate body, the template material and the first oxide, respectively. It will be appreciated that in general aₜ is intermediate a_{f} and 2aₛ. It will also be appreciated that the above inequality applies to the typical embodiment wherein the substrate body is a conventional material such as STO, YSZ or Si, but does not apply to the embodiment wherein the substrate is a s.s. oxide of lattice constant in the range 0.79-0.89 nm.

After formation of the layer combination according to the invention, conventional techniques will typically be used to form an electrical component or device that comprises the first oxide layer. Exemplarily, a patterned conductor (e.g., Al) is formed on the ferrite layer according to the invention, the combination providing an inductor that is suitable for operation at frequencies as high as 100 MHz or even 1 GHz. Among exemplary articles that can be made are integrated circuits with on-board components that comprise a ferrite layer according to the invention, and circuits formed on a substrate other than Si and then flip-chip attached to Si-ICs.

## Claims

1. Method of making an article that comprises a first spinel-structure metal oxide layer on a substrate, the method comprising
a) providing the substrate; and
b) depositing the first oxide layer on the substrate, the first oxide layer comprising a first oxide having lattice constant a_{f};
CHARACTERIZED IN THAT
step a) comprises
i) providing a crystalline substrate body (11) having a lattice constant aₛ and a major surface; and
ii) depositing a template layer (12) on the major surface, the template layer being a second spinel-structure metal oxide layer selected to have a lattice constant aₜ in the range 0.79-0.89 nm; and exposing the template layer to a temperature of at least 600°C for a time sufficient for crystal structure improvement; and
step b) comprises depositing the first oxide layer (13) on the template layer with improved crystal structure at a temperature of at most 500°C, and the article is completed without heating the first oxide layer above 500°C.

2. Method of claim 1, wherein the template layer is selected such that |*a*_{*f*} *-a*_{*t*} | ≤ 0.015 nm.

3. Method of claim 1, wherein the substrate body and the template layer are selected such that |*2a*_{*s*} *- a*_{*t*} |*>*|*a*_{*t*} *- a*_{*f*}|.

4. Method of claim 1, wherein the substrate body is selected from the group consisting of SrTiO₃, cubic zirconia, Si, MgAl₂O₄, MgAlGaO₄, MgO and Al₂O₃.

5. Method of claim 4, wherein the template layer is selected from the group consisting of CoCr₂O₄ and NiMn₂O₄.

6. Method according to claim 4, wherein the first oxide layer comprises a layer selected from the group consisting of MnₓZn_{y}Fe_{z}O₄, and NiₓZn_{y}Fe_{z}O₄, with 0 ≤ y < .6, 1.5 < z ≤ 2.5, x + y + z = 3, CoFe₂O₄ and Ni_{x'}Fe_{y'}Cr_{z'}, with 0.5 < x' < 1.5, 0.5 < y' < 1.5, 0.5 < z' < 1.5, and x' + y' + z' = 3.

7. Method of claim 1,wherein the first oxide layer comprises at least two metal oxide layers.

8. Method according to claim 1, wherein the first oxide layer comprises at least one ferrite layer, and the method further comprises forming a patterned conductor on said ferrite layer.

9. Method of claim 1, wherein the first metal oxide layer comprises a ferrite layer, and wherein the template layer comprises a non-ferrite metal oxide layer.

10. Method of claim 1, wherein exposing the template layer to a temperature of at least 600°C comprises
i) depositing the template layer at a temperature of at least 600°C;
ii) annealing the template layer at a temperature of at least 600°C; or
iii) both.

## Patentansprüche

1. Verfahren zur Herstellung eines Gegenstands, der auf einem Substrat eine Metalloxidschicht mit Spinellstruktur umfaßt, wobei das Verfahren folgendes umfaßt:
a) Bereitsstellen des Substrats; und
b) Abscheiden der ersten Oxidschicht auf dem Substrat, wobei die erste Oxidschicht ein erstes Oxid mit einer Gitterkonstanten a_{f} umfaßt;
dadurch gekennzeichnet, daß
Schritt a) folgendes umfaßt:
i) Bereitstellen eines kristallinen Substratkörpers (11) mit einer Gitterkonstanten aₛ und einer Hauptfläche; und
ii) Abscheiden einer Schablonenschicht (12) auf der Hauptfläche, wobei die Schablonenschicht eine zweite Metalloxidschicht mit Spinellstruktur ist, die so gewählt ist, daß sie eine Gitterkonstante aₜ im Bereich 0,79 - 0,89 nm aufweist; und Aussetzen der Schablonenschicht einer Temperatur von mindestens 600°C über einen zur Verbesserung der Kristallstruktur ausreichenden Zeitraum; und
Schritt b) das Abscheiden der ersten Oxidschicht (13) auf der Schablonenschicht mit verbesserter Kristallstruktur bei einer Temperatur von höchstens 500°C umfaßt und der Gegenstand ohne Erhitzen der ersten Oxidschicht über 500°C fertiggestellt wird.

2. Verfahren nach Anspruch 1, bei dem die Schablonenschicht so gewählt ist, daß |a_{f} - aₜ| ≤ 0,015 nm.

3. Verfahren nach Anspruch 1, bei dem der Substratkörper und die Schablonenschicht so gewählt sind, daß |2aₛ - aₜ| > |aₜ - a_{f}|.

4. Verfahren nach Anspruch 1, bei dem der Substratkörper ausgewählt ist aus der Gruppe bestehend aus SrTiO₃, kubischem Zirkonia, Si, MgAl₂O₄, MgAlGaO₄, MgO und Al₂O₃.

5. Verfahren nach Anspruch 4, bei dem die Schablonenschicht ausgewählt ist aus der Gruppe bestehend aus CoCr₂O₄ und NiMn₂O₄.

6. Verfahren nach Anspruch 4, bei dem die erste Oxidschicht eine Schicht umfaßt, die ausgewählt ist aus der Gruppe bestehend aus MnₓZn_{y}Fe_{z}O₄ und NiₓZn_{y}Fe_{z}O₄, wobei 0 ≤ y < 0,6, 1,5 < z ≤ 2,5, x + y + z = 3, CoFe₂O₄ und Ni_{x'}Fe_{y'}Cr_{z'}, wobei 0,5 < x' < 1,5, 0,5 < y' < 1,5, 0,5 < z' < 1,5 und x' + y' + z' = 3.

7. Verfahren nach Anspruch 1, bei dem die erste Oxidschicht mindestens zwei Metalloxidschichten umfaßt.

8. Verfahren nach Anspruch 1, bei dem die erste Oxidschicht mindestens eine Ferritschicht umfaßt und das Verfahren weiterhin das Bilden eines strukturierten Leiters auf der Ferritschicht umfaßt.

9. Verfahren nach Anspruch 1, bei dem die erste Metalloxidschicht eine Ferritschicht umfaßt und wobei die Schablonenschicht eine Nicht-Ferrit-Metalloxidschicht umfaßt.

10. Verfahren nach Anspruch 1, bei dem das Aussetzen der Schablonenschicht einer Temperatur von mindestens 600°C folgendes umfaßt:
i) Abscheiden der Schablonenschicht bei einer Temperatur von mindestens 600°C
ii) Tempern der Schablonenschicht bei einer Temperatur von mindestens 600°C; oder
iii) beides.

## Revendications

1. Procédé pour réaliser un article qui comprend une première couche d'oxyde métallique à structure en spinelle sur un substrat, le procédé comprenant
a) la fourniture du substrat ; et
b) le dépôt de la première couche d'oxyde sur le substrat, la première couche d'oxyde comprenant un premier oxyde ayant une constante de réseau a_{f} ;
caractérisé par
l'étape a) comprenant
i) la fourniture d'un corps de substrat cristallin (11) ayant une constante de réseau aₛ et une surface principale ; et
ii) le dépôt d'une couche modèle (12) sur la surface principale, la couche modèle étant une deuxième couche d'oxyde métallique à structure en spinelle choisie pour avoir une constante de réseau aₜ dans la plage 0,79 - 0,89 nm ; et l'exposition de la couche modèle à une température minimale de 600°C pendant une durée suffisante pour améliorer la structure du cristal ; et
l'étape b) comprenant le dépôt de la première couche d'oxyde (13) sur la couche modèle avec sa structure cristalline améliorée à une température maximale de 500°C, et l'article est terminé sans chauffer la première couche d'oxyde à plus de 500°C.

2. Procédé selon la revendication 1 dans lequel la couche modèle est choisie de manière à ce que |a_{f} - aₜ| ≤ 0,015 nm.

3. Procédé selon la revendication 1 dans lequel le corps du substrat et la couche modèle sont choisis de manière à ce que |2aₛ - aₜ| > |aₜ - a_{f}|.

4. Procédé selon la revendication 1 dans lequel le corps du substrat est choisi dans le groupe composé de SrTiO₃, zircone cubique, Si, MgAl₂O₄, MgAlGaO₄, MgO et Al₂O₃.

5. Procédé selon la revendication 4 dans lequel la couche modèle est choisie dans le groupe composé de CoCr₂O₄ et NiMn₂O₄.

6. Procédé selon la revendication 4 dans lequel la première couche d'oxyde comprend une couche choisie dans le groupe composé de MnₓZn_{y}Fe_{z}O₄ et NiₓZn_{y}Fe_{z}O₄ avec 0 ≤ y < 0,6, 1,5 < z ≤ 2,5, x + y + z = 3, CoFe₂O₄ et Ni_{x'}Fe_{y'}Cr_{z'} avec 0,5 < x' < 1,5, 0,5 < y' < 1,5, 0,5 < z' < 1,5 et x' + y' + z' = 3.

7. Procédé selon la revendication 1 dans lequel la première couche d'oxyde comprend au moins deux couches d'oxyde métallique.

8. Procédé selon la revendication 1 dans lequel la première couche d'oxyde comprend au moins une couche en ferrite et le procédé comprend en plus la formation d'un conducteur façonné sur ladite couche en ferrite.

9. Procédé selon la revendication 1 dans lequel la première couche d'oxyde comprend une couche en ferrite et dans lequel la couche modèle comprend une couche d'oxyde métallique qui n'est pas en ferrite.

10. Procédé selon la revendication 1 dans lequel l'exposition de la couche modèle à une température minimale de 600°C comprend
i) le dépôt de la couche modèle à une température minimale de 600°C ;
ii) le recuit de la couche modèle à une température minimale de 600°C ; ou
iii) les deux.
